# EUROPEAN PATENT APPLICATION

(11) **EP 4 727 044 A1**
(43) Date of publication of application: **15.04.2026**
(21) Application number: 25207725.0
(22) Date of filing: 09.10.2025
(51) Int. Cl.: H04L 1/00, H03M 13/15, H03M 13/29, H03M 13/00

(54) **APPARATUS AND METHODS FOR FORWARD ERROR CORRECTION**

(30) Priority: 09.10.2024 US 202463705293 P
(71) Applicant: Infinera Corporation, San Jose, CA 95119 (US)
(72) Inventor: LE TRUNG, Khoa, San Jose, 95119 (US); CONDO, Carlo, San Jose, 95119 (US); SUN, Han, San Jose, 95119 (US); LAND, Ingmar, 92190 Meudon (FR)
(74) Representative: Novagraaf Technologies

(57) **Abstract**

Encoding an input data stream comprises distributing the bits of the input data stream across an Open Forward Error Correction (OFEC) codeword matrix and encoding the matrix with an OFEC code. Within the matrix, an integer number 8, 6, or 4 of rows of blocks of bits are guard rows that separate front bits from back bits. The encoding is performed by, respectively, 4, 6, or 8 parallel digital processing circuits.

## Description

### Technical Field

The disclosure relates to optical modems, and more particularly to implementations of forward error-correcting coding for high-speed optical transmission and reception.

### Cross-Reference to Related Application

This application claims the benefit of Provisional Application Serial No. 63/705,293 filed on October 9, 2024.

### Art Background

There is continuing interest in increasing the capability of optical fiber communication systems for high-speed transmission. Standards for optical transmitters capable of data rates as high as 800G, i.e., 800 Gigabits per second, have been issued by standards bodies. Examples include the 800ZR Coherent Interface Implementation Agreement issued in 2024 by the Open Internet Forum, and the OpenROADM MSA 6.0 issued in 2023 by the OpenROADM Multi-Source Agreement (MSA) Group.

By way of example, 800G optical communication is used in modern networking technologies like Optical Transport Networks (OTN), Ethernet, and InfiniBand. Among other reasons, rates of 800G and above are of interest because they can provide ultra-high bandwidth for applications in data centers, cloud computing, high-performance computing (HPC), Artificial Intelligence (AI), and telecommunication networks.

The OIF 800ZR standard, the OpenROADM MSA 5.0 standard, and the OpenROADM MSA 6.0 standard, among others, use OpenFEC ("OFEC") as the coding scheme for forward error correction. Open ROADM has adopted the same implementation for metro optical transport applications.

Both OIF 800ZR and OpenROADM MSA 6.0 call for four digital processors operating in parallel to perform the OFEC coding and decoding, with each processor supporting a data rate of 200G.

There is interest in extending the capabilities of optical modems to 1.6T, i.e., 1600 Gigabit per second, transmission and reception, and to even higher rates. However, difficulties arise, not least of which are that some technical accommodations to the higher speeds may be incompatible with current standards.

There is, therefore, a continuing need for practical and feasible approaches for optical communication at rates of 1.6T and beyond.

### Summary

In a first aspect, the disclosure relates to a method, comprising processing an input data stream to produce an encoded output data stream, and transmitting the encoded data stream. The processing comprises, one or more times, obtaining a string of bits from an input data stream, distributing the bits across an OFEC codeword matrix in which square blocks of bits are arranged in rows and columns of the matrix, and encoding the matrix with an OFEC code.

The distributing of bits comprises placing front bits in designated front bit positions and placing back bits in designated back bit positions. Within the matrix, an integer number 2G of rows of the said blocks of bits are guard rows that separate the front bits from the back bits. The encoding is performed by an integer number N of parallel digital processing circuits, wherein N has the value 4, 6, or 8, and 2G has a corresponding, respective value of 8, 6, or 4.

In embodiments, the N parallel digital processing circuits are each operated at a data rate of 1600/N Gigabits per second.

In embodiments, N=4 and 2G=8. In such embodiments, the N=4 parallel digital processing circuits may each operated at a data rate of 400 Gigabits per second.

In embodiments, N=6 and 2G=6. In such embodiments, the N=6 parallel digital processing circuits may each be operated at a data rate of 267 Gigabits per second.

In embodiments, N=8 and 2G=4. In such embodiments, the N parallel digital processing circuits may each operated at a data rate of 200 Gigabits per second.

In embodiments, the encoded data stream is transmitted as an optical signal in an optical fiber network. In some embodiments, for example, the encoding may be performed at the transmitter side of a coherent optical transceiver or coherent optical modem.

In a second aspect, the disclosure relates to apparatus, comprising circuitry configured to obtain a string of bits from an input data stream and to distribute the bits across an OFEC codeword matrix in which square blocks of bits are arranged in rows and columns of the matrix. The apparatus further comprises circuitry configured to encode the matrix with an OFEC code, thereby to produce an encoded matrix, circuitry configured to generate an output data stream from the encoded matrix, and optical output circuitry configured to optically modulate the output data stream onto one or more optical carriers to produce an output optical signal, and to transmit the output optical signal.

The circuitry is so configured that the distributing of bits comprises placing front bits in designated front bit positions and placing back bits in designated back bit positions, and that within the matrix, an integer number 2G of rows of the blocks of bits are guard rows that separate the front bits from the back bits. The circuitry configured to encode the matrix with an OFEC code comprises an integer number N of parallel digital processing circuits, wherein N has the value 4, 6, or 8 and 2G has a corresponding, respective value of 8, 6, or 4.

In embodiments, N=4 and 2G=8. In such embodiments, the N=4 parallel digital processing circuits may each be operated at a data rate of 400 Gigabits per second.

In embodiments, N=6 and 2G=6. In such embodiments, the N=6 parallel digital processing circuits may each be operated at a data rate of 267 Gigabits per second.

In embodiments, N=8 and 2G=4. In such embodiments, the N=8 parallel digital processing circuits may each be operated at a data rate of 200 Gigabits per second.

In embodiments, the optical output circuitry is configured to transmit the encoded data stream as an optical signal in an optical fiber network.

In embodiments, the circuitry configured to obtain a string of bits and to distribute the bits, the circuitry configured to encode the matrix, the circuitry configured to generate an output data stream, and the optical output circuitry are comprised within a coherent optical transceiver or coherent optical modem.

In embodiments, the apparatus is configurable between a first operating mode and a second operating mode. In the first operating mode, N parallel digital processing circuits are each enabled to operate at a data rate of 1600/N Gigabits per second. In the second operating mode, only four of the N parallel digital processing circuits are enabled to operate, and for each of the four parallel digital processing circuits, said operation is enabled at a data rate of 200 Gigabits per second.

### Definitions

As used herein, the terms "front bit" and "back bit" have the following meanings:
A "front bit" is a bit of an OFEC constituent component codeword that belongs to the portion of the codeword that is distributed, in the OFEC encoder memory, within a diagonal arrangement of blocks of 16×16 bits.
A "back bit" is a bit of an OFEC constituent component codeword that belongs to the portion of the codeword that is horizontally distributed, in the OFEC encoder memory, across blocks within a single row of blocks of 16×16 bits.
The quantity "200G" or "200 Gigabits per second" or "200Gb/s", as used herein to describe a data rate or the like, means a speed for the transmission of data within or between devices that supports transmission at 200 Gigabits per second and is within established tolerances for compliance with standards for 200G communication. In practice, 200G transmission may be transmission at 200 Gigabits per second, or transmission at a modestly higher speed to accommodate coding redundancy and other overhead.
The quantity "800G" or "800 Gigabits per second" or "800Gb/s", as used herein to describe a data rate or the like, means a speed for the transmission of data within or between devices that supports transmission at 800 Gigabits per second and is within established tolerances for compliance with standards for 800G communication. In practice, 800G transmission may be transmission at 800 Gigabits per second, or transmission at a modestly higher speed to accommodate coding redundancy and other overhead.

Other quantities used herein to describe a data rate or the like, likewise mean a speed for the transmission of data within or between devices that supports transmission at the stated rate.

### Brief Description of the Drawings

FIG. 1 illustrates an OFEC encoding process and the placement of an OFEC codeword in the bit memory used by an OFEC encoder.
FIG. 2 illustrates one stage of an OFEC decoding process and the retrieval of an OFEC codeword in the bit memory used by an OFEC decoder.
FIG. 3 illustrates the combining and downstream processing of the outputs of four respective parallel encoders.
FIG. 4 illustrates the pre-processing of a received signal and its downstream processing by four respective parallel decoders.
FIG. 5 illustrates an encoding implementation using eight processors operating in parallel according to an embodiment described herein.
FIG. 6 illustrates a decoding implementation using eight processors operating in parallel according to an embodiment described herein.
FIG. 7 illustrates an OFEC encoding process and the placement of an OFEC codeword in the bit memory used by an OFEC encoder in an implementation using eight guard rows according to an embodiment described herein.
FIG. 8 is a highly simplified block diagram of a typical coherent optical transceiver.

### Detailed Description

OFEC coding schemes are well-known in the art and need not be described here in detail. For pedagogical purposes only, and not for purposes of limitation, we will now very briefly describe an example of an OFEC codeword that conforms to the standards cited above.

The input to the coder is processed as a set of 84 coder blocks of 14,208 bits each. For each block, these bits are distributed at a granularity of 1-bit to four parallel OFEC encoders in a round-robin fashion. Each OFEC encoders processes a 3552-bit input block to generate a 4096-bit output block. The output of the OFEC encoders is interleaved to improve the burst tolerance of the code.

The OFEC codeword produced by the OFEC encoders is a semi-infinite set of bits organized in a matrix with semi-infinite number of rows, and N=128 columns. Each bit is part of two "constituent component codewords," in which each constituent component codeword is a binary vector x of length 2N satisfying the parity-check constraints of a Bose-Chaudhuri-Hocquenghem (BCH) code. Each constituent component codeword has 17 parity bits.

The infinite matrix of bits is partitioned in square blocks of B x B bits (B = 16), arranged in rows and columns. There are N/B blocks per row (N/B=8). The bits of a constituent component codeword are partitioned between "front bits" and "back bits". The front bits are vertically distributed within each block in a descending, diagonal arrangement of blocks of the matrix. The back bits are horizontally distributed, across blocks within a single row of the matrix. Each bit in the OFEC encoder belongs to the front of a constituent component codeword and to the back of another one.

Relative to each respective constituent component codeword, there are an integer number 2G of rows of square blocks located below the "front bits" and above the "back bits" of that respective constituent component codeword. These blocks are the so-called guard blocks, relative to that respective constituent component codeword, and the rows that they occupy are the "guard rows" for that constituent component codeword.

Encoding is done sequentially in order of increasing row index. After encoding, the N back bits are placed at their positions in the infinite matrix, and bits in their positions are output to the interleaver. It should be noted in this regard that bits are input for encoding at the bottom of the encoder memory, and encoded output is taken from the top of the encoder memory.

The parameter 2G is made large enough to allow sufficient time for the parallel encoding and decoding operations. A large value for 2G allows for longer pipeline delays in the encoding and decoding operations and allows for more parallel execution in the encoder and decoder, at the expense of increased memory.

More specifically, the OFEC code definition adopted in 800ZR and OpenROADM MSA 6.0 for 800G transmission specifies a "row gap" of 2G = 4 rows. This row gap introduces a certain latency, which affords the OFEC decoder sufficient time to do the processing while supporting a throughput of 200G.

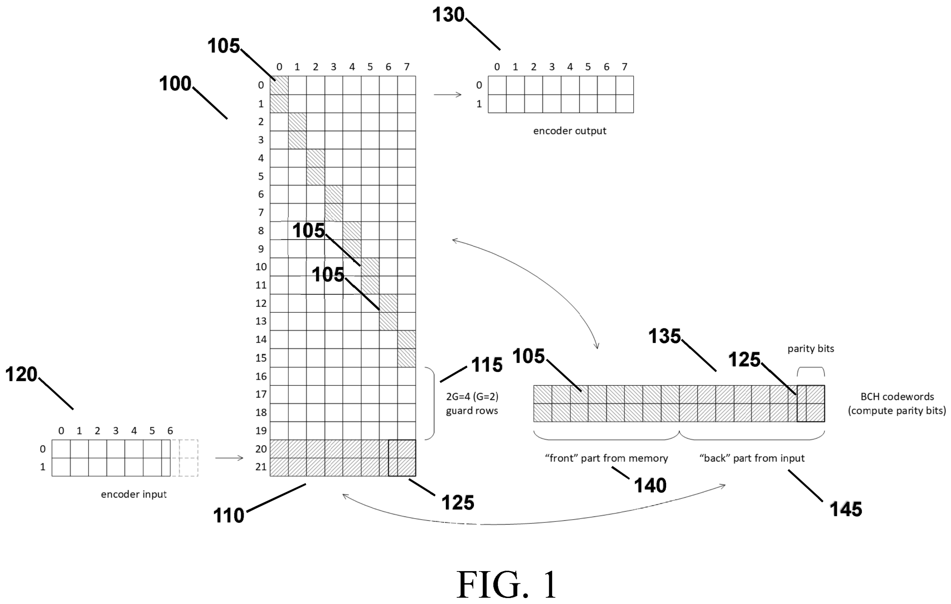

The features described above will be better understood with reference to FIG. 1, to which the following discussion is directed.

As shown in FIG. 1, there is a matrix **100** of 22×8 blocks of 16×16 bits each. With respect to a particular constituent component codeword chosen for illustrative purposes, the shaded blocks **105** in rows 0-15 contain the front bits, and the shaded blocks **110** in rows 20-21 contain the back bits. The guard rows **115** with respect to the chosen constituent component codeword are rows 16-19.

In every encoding step, the OFEC encoder takes, as input **120,** 32×111=3552 bits. These go into the bottom of the memory **100,** block-rows 20 and 21. There will be 32×17 bits **125** remaining at the right-hand end of the row. These are the redundant parity bits to be computed. They are a function of the current input bits **120** and of the front bits **105,** which are already in the memory in the shaded diagonal shown in FIG 1.

After these 32×17 bits are computed, they are placed in the memory in block-rows 20 and 21, and the top two block-rows 0 and 1 are pushed out. These are the 32x128=4096 output bits of the FEC encoder. The memory is pushed up by two block-rows.

Detail **135** will be seen on the right-hand side of FIG. 1. Detail **135** is presented as an aid to understanding the computation of the 32×17 parity bits. The left-hand portion **140** of detail **135** represents front bits **105,** and the right-hand portion **145** represents back bits **125.** Each of the front 32×128 bits are taken from the diagonal part of the memory, shown as shaded in the figure. The back 32×128 bits are the input bits, with the right-most 32×17 parity bits that are to be computed.

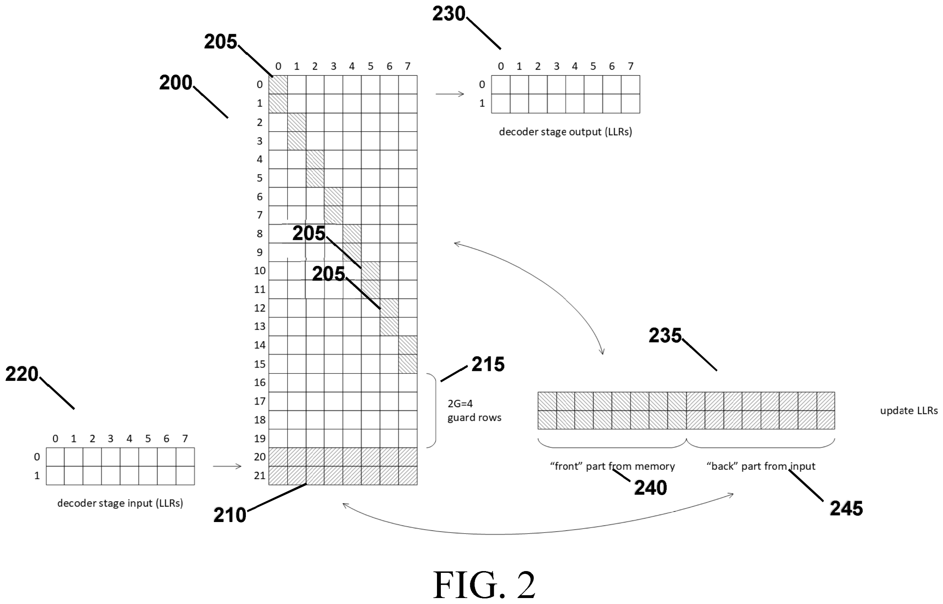

We will now very briefly describe the decoding process in the OFEC decoder on the receiver side of a communication link. The decoding process is best understood with reference to FIG. 2, to which attention is now directed.

At the receiver, the decoding is an iterative process that proceeds through several decoding stages. Each decoding stage refines the results of the preceding stage so that more errors are corrected. At each decoding stage, the decoder memory **200** is defined, substantially, as a mirror image of the encoder memory **100.**

For each bit in the transmitter, there is a corresponding log-likelihood ratio ("LLR") on the receiver side. The initial LLRs are typically produced at the receiver by a demapper. As the decoding progresses through successive stages, the LLRs may change in value, with some values possibly changing sign, and some values possibly changing in amplitude.

At the receiver, the LLRs are pushed in blocks **220** of 32×128 = 4096 through the decoder memory **200.** While this is happening, the actual decoder takes the "front" LLRs **205** and the "back" LLRs **210** from the memory **200,** updates them, and then writes them back. This updating takes time. While this is happening, the data is kept pushing through the memory. The guard rows **215** (of total number 2G=4) provide time for this updating and decoding process.

In FIG. 2, inset **230** represents the LLRs output from a single decoder stage. Inset **235** illustrates the updating of the LLRs during a decoder stage. The left-hand portion **240** of inset **235** represents front LLRs **205,** and the right-hand portion **245** of inset **235** represents back LLRs **210.**

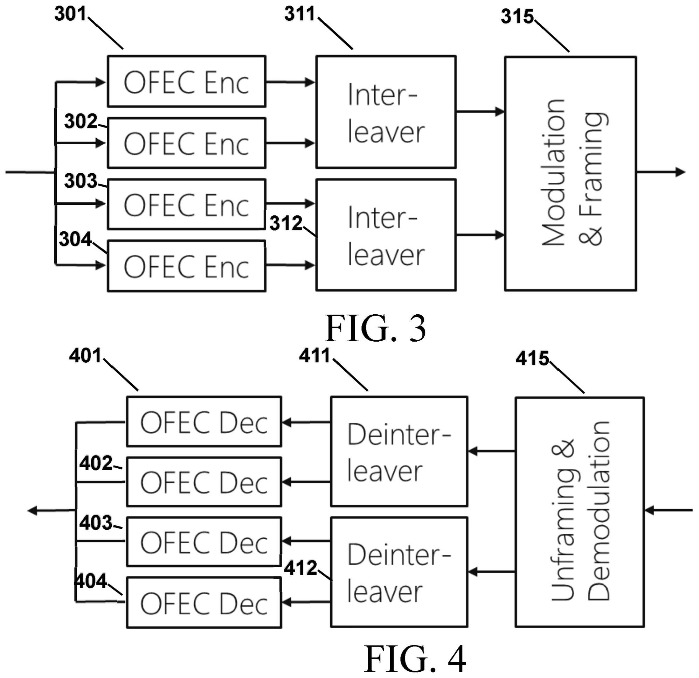

FIG. 3 illustrates how, at the transmitter, the outputs of the four respective parallel encoders **301-304** are further processed. As shown in the figure, Interleaver **311** combines the output streams of Encoder **301** and Encoder **302,** while Interleaver **312,** operating in parallel, combines the output streams of Encoder **303** and Encoder **304.** The interleaver outputs are passed forward for further digital processing, which includes modulation and framing **315.**

FIG. 4 illustrates how, at the receiver, the received signal is pre-processed prior to decoding by the four respective parallel decoders **401-404.** As shown in the figure, downstream of unframing and demodulation **415,** deinterleaver **411** provides input for decoder **401** and decoder **402,** while deinterleaver **412,** operating in parallel, provides input for decoder **403** and decoder **404.**

The example OFEC coding scheme described above was specified for a throughput of 800G. We investigated the possibility of doubling this throughput to 1600G. We analyzed a possible approach using four parallel OFEC coders and decoders, and a possible approach that doubles the number of parallel OFEC coders and decoders to a total of eight.

Our analysis showed, among other things, that a single OFEC decoder as defined in above-cited standards, with a row gap of 2G=4, would not support a throughput of 400G, i.e., a throughput of one-fourth 1600G. Increasing the throughput required of the OFEC decoder from 200G to 400G would halve the available time for processing the data, including updating the LLRs.

We determined, and our analyses confirmed, that it would be feasible and practical to double the number of OFEC coders and decoders from four to eight, with each OFEC decoder still operating at a data rate of 200G. Our analysis further confirmed that with the row gap maintained at 2G=4, there would still be sufficient latency for successful decoding at 1600G. This offers the great benefit that the definition of the OFEC code does not need to be changed.

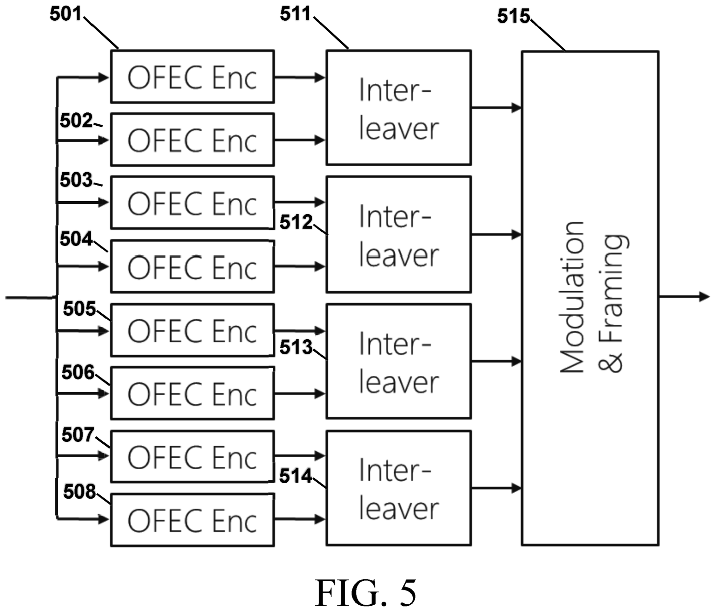

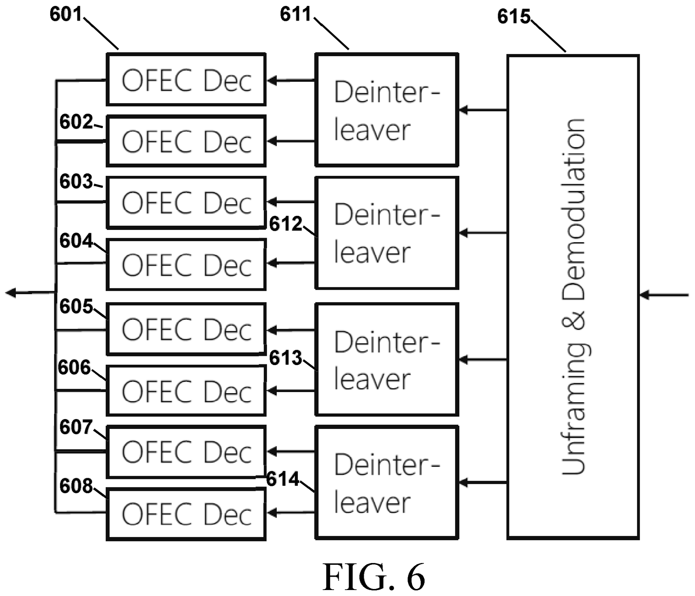

Accordingly, a first embodiment, illustrated in FIGS. 5 and 6, relates a coding and decoding implementation using eight processors operating in parallel. FIG. 5 illustrates a coding implementation, and FIG. 6 illustrates a corresponding decoding implementation.

Turning to FIG. 5, encoding is performed in parallel by encoders **501-508.** Interleavers **511-514,** operating in parallel, each combine the output streams from a respective pair of encoders. The interleaver outputs are passed forward for further digital processing, which includes modulation and framing **515.**

Turning to FIG. 6, the received signal goes through unframing and demodulation **615,** followed by deinterleavers **611-614** operating in parallel. Each of the deinterleavers **611-614** provides input for a respective pair of the decoders **601-608.**

As mentioned above, we determined that a single OFEC decoder as defined in above-cited standards, with a row gap of 2G=4, would not support a throughput of 400G. We considered various ways to increase the throughput of the decoder. One possibility for increasing the throughput of the decoder is to increase the clock speed. Another possibility is to speed up the processing through optimization of the algorithm or of the circuit design that implements it.

We concluded that a modest increase in speed could be achieved through routine design modifications, preferably without a need to also increase the clock speed. However, in order to support a single-processor throughput of 400G, we found it would also be necessary to increase the row gap to 2G=8.

Our analyses confirmed that it would be feasible and practical to support a rate of 1600G using four 400G encoders and decoders, with latency added by increasing the row gap to 2G=8. Although this has the disadvantage that it would call for a modification to the applicable standards, it has the benefit of conserving power and chip area.

For example, an estimate of the chip area needed for the OFEC encoder and decoder and for the interleaver and deinterleaver showed that, relative to an 800G modem with 200G processors in groups of four, our eight-processor implementation would require double the chip area, whereas our four-processor implementation would require only 1.4 times the chip area. Similarly, a power estimate showed that our eight-processor implementation would require about twice the power of the reference modem, whereas our four-processor implementation would require only about 1.7 times the power of the reference modem.

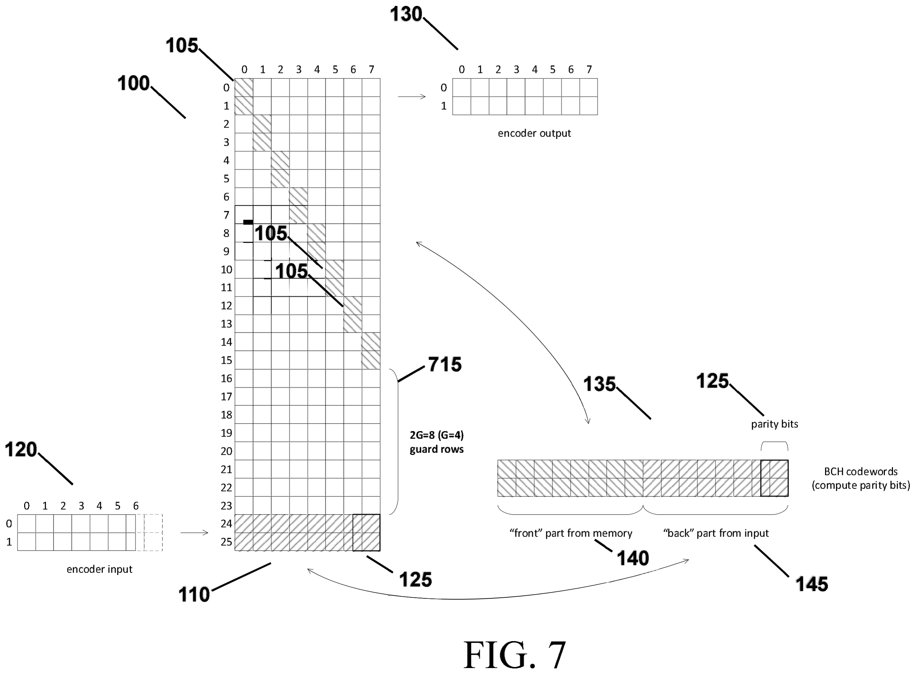

Accordingly, a second embodiment, as illustrated in FIG. 7, relates to a coding and decoding implementation in which four 400G encoders operate in parallel, four 400G decoders operate in parallel, and the encoder and decoder memories each have a total of eight guard rows. Numbered features of FIG. 7 have the same meaning as like numbered features of FIG. 1. However, in contrast to the four guard rows **115** of FIG. 1, the guard rows **715** of FIG. 7 have been increased in number to a total of eight.

In a third embodiment, not expressly shown in the figures, the total number of 200G OFEC encoders, and likewise the total number of 200G decoders, is six. In such an embodiment, each OFEC encoder, and each OFEC decoder, supports a rate of 1600G/6=267 Gigabits per second. In that embodiment, the encoder and decoder memories each have a total of six guard rows. On the basis of our analyses of the first two embodiments, we believe that this third embodiment is likewise feasible and practical.

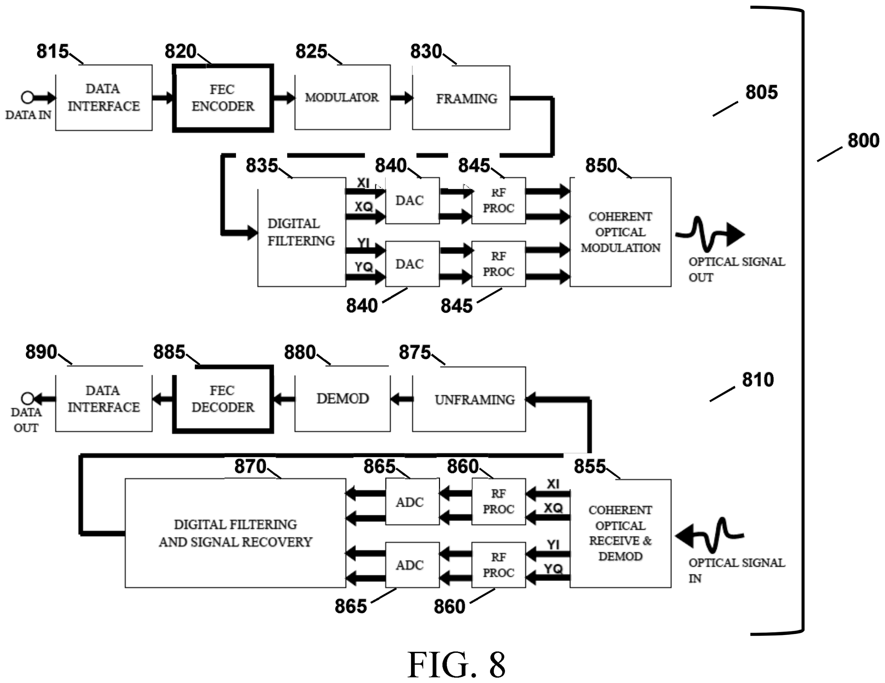

FIG. 8 is a highly simplified block diagram of a typical optical coherent transceiver 800, provided here for pedagogical purposes and not meant to be limiting as to the processing steps or as to the mode or means of their performance. The transceiver includes a transmitter side **805** and a receiver side **810.**

At transmitter side **805,** the bitstream representing the initial data passes, as shown, through data interface **815,** FEC encoder **820,** modulator **825,** and framer **830.** The framer output is subjected to digital filtering **835.** As shown in the figure, the digitally filtered output may have two polarization channels X and Y, and each polarization channel may have an in-phase component I and a quadrature component Q. The digitally filtered output undergoes digital-to-analog conversion **840,** and the resulting analog signal undergoes radiofrequency processing **845** and at block **850** is used to modulate the analog signal onto one or more optical carriers to produce an optical signal that is then transmitted.

The processes described above for OFEC encoding would typically be carried out at block **820** of the figure, labeled "FEC Encoder".

At receiver side **810,** the incoming optical signal undergoes coherent optical detection and demodulation **855.** As shown in the figure, the optically demodulated output may have two polarization channels X and Y, and each polarization channel may have an in-phase component I and a quadrature component Q. The optically demodulated signal undergoes RF processing **860,** analog-to-digital conversion **865,** and digital filtering and signal recovery **870.** The digitally filtered signal then passes through unframer **875,** demodulator **880,** FEC decoder **885,** and data interface **890** to produce the output, which is the received data signal.

The processes described above for OFEC decoding would typically be carried out at block **885** of the figure, labeled "FEC Decoder".

It should be noted that it would be typical, at both the transmitter side and the receiver side, for each of the respective signal branches XI, XQ, YI, and YQ to have its own respective RF processing circuitry and its own respective ADC or DAC circuitry. For simplicity of presentation, some of these circuits have been combined in FIG. 8.

For at least some applications, it would be desirable for a 1600G modem to be backward compatible to 800G. One possible approach would be duplicative. That is, a 1600G transmitter and receiver, and an 800G transmitter and receiver could be separately implemented.

A more efficient implementation would reuse elements of the 1600G transmitter and receiver for 800G transmission and reception. A non-limiting example is conveniently described with reference to FIG. 5, which shows a transmitter with eight OFEC encoders in parallel. To configure the transmitter for 800G, only a subset of four of the OFEC encoders is enabled, exemplarily encoders **501-504,** and likewise only the corresponding interleavers, exemplarily interleavers **511** and **512** would be enabled. Within processing block **515** of the figure, the outputs of only the two enabled interleavers would be merged, rather than the outputs of all four interleavers.

The circuitry for carrying out the OFEC encoding and decoding operations would typically be constituted by special-purpose, high-speed, integrated circuits. Other possibilities, which should not be understood as excluded from the scope of the present disclosure, include special and general purpose digital signal processors and general purpose computers suitably programmed and operating under software control.

The foregoing merely illustrates the principles of the invention. It will thus be appreciated that those skilled in the art will be able to devise various arrangements that, although not explicitly described or shown herein, embody the principles of the invention and are included within its spirit and scope.

Furthermore, all examples and conditional language recited herein are principally intended expressly to be only for pedagogical purposes to aid the reader in understanding the principles of the invention and the concepts contributed by the inventors to furthering the art, and are to be construed as being without limitation to such specifically recited examples and conditions.

Moreover, all statements herein reciting principles, aspects, and embodiments of the invention, as well as specific examples thereof, are intended to encompass both structural and functional equivalents thereof.

Additionally, it is intended that such equivalents include both currently known equivalents as well as equivalents developed in the future, i.e., any elements developed that perform the same function, regardless of structure. Thus, for example, it will be appreciated by those skilled in the art that any block diagrams herein represent conceptual views of illustrative circuitry embodying the principles of the invention.

In the claims hereof any element expressed as a means for performing a specified function is intended to encompass any way of performing that function. This may include, for example, (a) a combination of electrical or mechanical elements which performs that function, or (b) software in any form, including, therefore, firmware, microcode or the like, combined with appropriate circuitry for executing that software to perform the function, as well as mechanical elements coupled to software controlled circuitry, if any. The invention as defined by such claims resides in the fact that the functionalities provided by the various recited means are combined and brought together in the manner which the claims call for. Applicant thus regards any means which can provide those functionalities as equivalent as those shown herein.

## Claims

1. A method, comprising processing an input data stream to produce an encoded output data stream, and transmitting the encoded data stream, wherein the processing comprises, one or more times:
obtaining a string of bits from an input data stream;
distributing the bits across an Open Forward Error Correction (OFEC) codeword matrix in which square blocks of bits are arranged in rows and columns of the matrix; and
encoding the matrix with an OFEC code;
wherein:
the distributing of bits comprises placing front bits in designated front bit positions and placing back bits in designated back bit positions;
within the matrix, an integer number 2G of rows of the said blocks of bits are guard rows that separate the front bits from the back bits;
the encoding is performed by an integer number N of parallel digital processing circuits;
N has the value 4, 6, or 8; and
2G has a corresponding, respective value of 8, 6, or 4.

2. The method of claim 1, wherein the N parallel digital processing circuits are each operated at a data rate of 1600/N Gigabits per second.

3. The method of claim 1, wherein N is equal to 4 and 2G is equal to 8.

4. The method of claim 3, wherein the N=4 parallel digital processing circuits are each operated at a data rate of 400 Gigabits per second.

5. The method of claim 1, wherein N is equal to 6 and 2G is equal to 6.

6. The method of claim 5, wherein the N=6 parallel digital processing circuits are each operated at a data rate of 267 Gigabits per second.

7. The method of claim 1, wherein N is equal to 8 and 2G is equal to 4.

8. The method of claim 7, wherein the N=8 parallel digital processing circuits are each operated at a data rate of 200 Gigabits per second.

9. The method of claim 1, wherein the encoded data stream is transmitted as an optical signal in an optical fiber network.

10. The method of claim 1, wherein the encoding is performed at the transmitter side of a coherent optical transceiver or coherent optical modem.

11. An apparatus comprising means for performing the method of any of claims 1 to 10.
